# EUROPEAN PATENT SPECIFICATION

(11) **EP 3 057 386 B1**
(45) Date of publication and mention of the grant of the patent: **21.06.2017**
(21) Application number: 15155016.7
(22) Date of filing: 13.02.2015
(51) Int. Cl.: H05K 7/14

(54) **Slide rail assembly**
Schienenanordnung
Ensemble de rail de glissement

(43) Date of publication of application: 17.08.2016
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Wang, Chun-Chiang, Kaohsiung City (TW)
(74) Representative: Viering, Jentschura & Partner mbB Patent- und Rechtsanwälte

(56) References cited:
- EP-A1- 2 438 835
- EP-A1- 2 446 779
- WO-A2-2004/024186

## Description

### Field of the Invention

The present invention relates to a slide rail assembly and more particularly to a slide rail assembly with a reinforcement structure.

### Background of the Invention

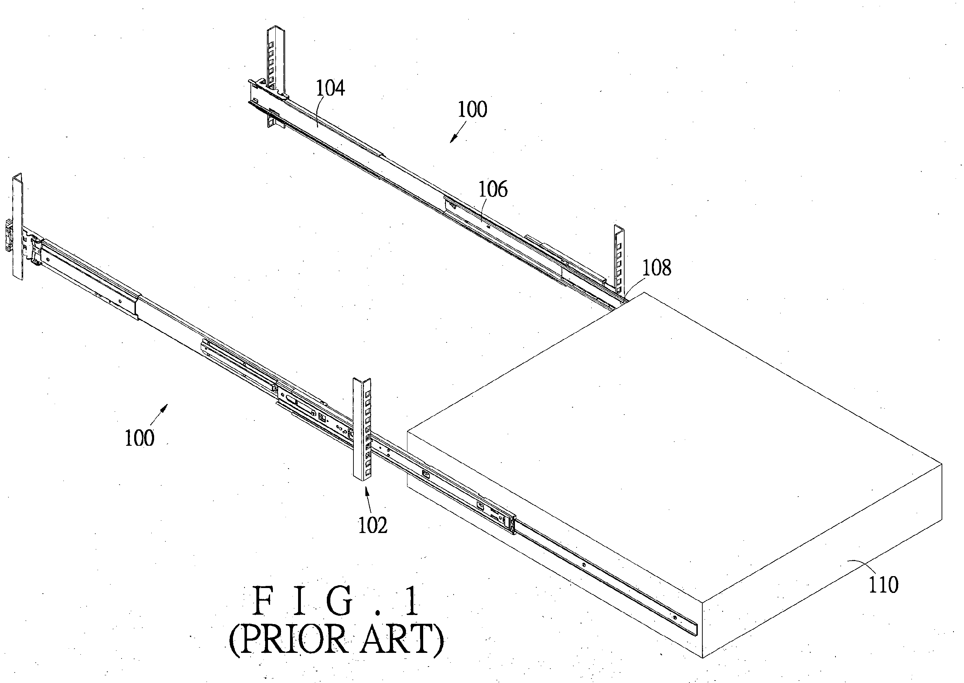

FIG. 1 shows how a pair of slide rail assemblies 100 are mounted to a rack 102 in a conventional server system. Typically, each slide rail assembly 100 includes a first rail 104, a second rail 106, and a third rail 108 sequentially connected together, wherein the second rail 106 and the third rail 108 can be longitudinally displaced relative to the first rail 104. An object 110 (e.g., a server or other electronic equipment) is mounted between the third rails 108 of the pair of slide rail assemblies 100. When the third rail 108 of each slide rail assembly 100 is fully pulled out and therefore at an extended position with respect to the first rail 104, the second rail 106 is also at an extended position with respect to the first rail 104 and is located between the first rail 104 and the third rail 108.

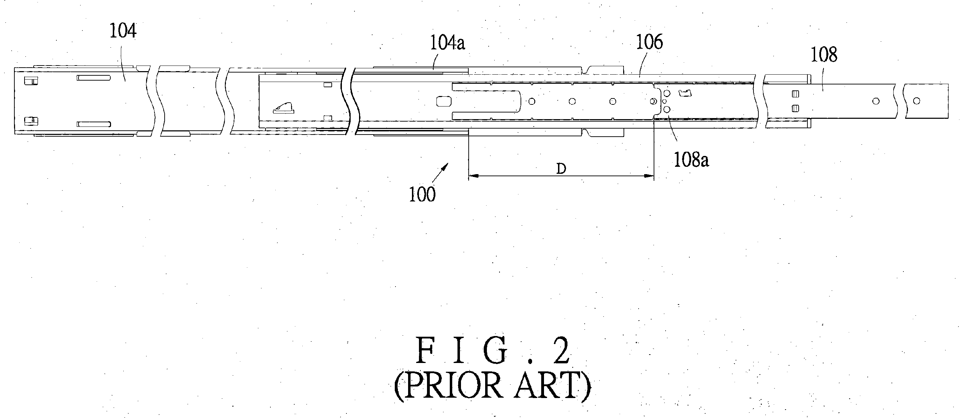

Referring to FIG. 2 in conjunction with FIG. 1, when the third rail 108 of each slide rail assembly 100 is fully pulled out and at the extended position with respect to the first rail 104, it is often the case that the third rail 108 has been pulled excessively with respect to the first rail 104, meaning the rear section 108a of the third rail 108 is a distance D away from the front section 104a of the first rail 104. Consequently, the weight of the object 110 mounted on the third rails 108 is borne mostly by the second rails 106, which tend to deform or bend if this weight bearing arrangement occurs repeatedly or lasts for a long time. In an environment where the object 110 and the rack 102 have fixed specifications, therefore, finding a way to structurally reinforce specific portions of the slide rail assemblies 100 in the limited space available is an important issue in improving the slide rail assemblies 100 in terms of use.

WO 2004/025186 A1 discloses a rail or telescopic extension for the horizontal or vertical extension of a cupboard element, a baking shelf, an oven door or similar. Said extension comprises at least one outer rail of bent sheet metal and a sliding rail consisting of bent sheet metal that partially surrounds said outer rail and can be displaced along the latter by means of an anti-friction bearing. The rail extension embodiment is provided with an outer attachment rail that is connected to and reinforces the outer rail and/or an attachment rail that is connected to and reinforces the sliding rail. The telescopic extension embodiment consists of two interconnected rail extensions, which are joined together by respective flat base sections of their attachment rails.

EP 2 446 779 A1 discloses a slide rail assembly with a quick-mount system including an outer rail, an intermediate rail an inner rail and a ball bearing retainer.

### Summary of the Invention

The present invention relates to a slide rail assembly with a reinforcement structure according to claim 1.

According to one aspect of the present invention, a slide rail assembly includes a first rail, a second rail, and a third rail. The second rail is movably connected to the first rail and includes a reinforcement structure, wherein the second rail includes a front portion and a rear portion, and the reinforcement structure is located between the front portion and the rear portion, and wherein the reinforcement structure includes a first portion and a second portion opposite the first portion and wherein the reinforcement structure is a plate longitudinally and fixedly connected to the second rail. The third rail is movably connected to the second rail. When the slide rail assembly is in a fully pulled out position, each of the second rail and the third rail is at an extended position with respect to the first rail, the second rail is located between the first rail and the third rail, the first portion of the reinforcement structure is at a position corresponding to the third rail, and the second portion of the reinforcement structure is at a position corresponding to the first rail; and the slide rail assembly is adapted for mounting an object to a rack; and wherein the first rail is mounted to the rack, and the third rail is mounted with the object.

According to another aspect of the present invention, a slide rail assembly adapted for mounting an object to a rack includes a first rail, a second rail, and a third rail. The first rail is mounted to the rack. The second rail is movably connected to the first rail and includes a reinforcement structure, wherein the reinforcement structure includes a first portion and a second portion opposite the first portion. The third rail is movably connected to the second rail and is mounted with the object. When the slide rail assembly is in a fully pulled out position, each of the second rail and the third rail is at an extended position with respect to the first rail, the second rail is located between the first rail and the third rail, the first portion of the reinforcement structure is at a position corresponding to the third rail, and the second portion of the reinforcement structure is at a position corresponding to the first rail.

According to yet another aspect of the present invention, a slide rail assembly includes a first rail, a second rail, and a third rail. The second rail is located between the first rail and the third rail and includes an upper wall, a lower wall, and a sidewall extending and connected between the upper wall and the lower wall. The sidewall includes a first surface and a second surface opposite the first surface. The first surface faces the third rail while the second surface faces the first rail. The second rail further includes a reinforcement structure connected to the second rail and located between the second surface of the second rail and the first rail.

Alternatively, in other embodiments, the reinforcement structure is longitudinally and integrally formed with the second rail and is in the form of a rib.

In some embodiments of any of the above aspects, the first rail is mounted to the rack via two brackets.

In some embodiments of any of the above aspects, the second rail further includes a recess in the second surface, and the reinforcement structure is fixedly connected to the second rail and located in the recess.

One of the advantageous features of employing the present invention is that the reinforcement structure increases the structural strength of the second rail.

### Brief Description of the Drawings

The structure as well as a preferred mode of use and the advantages of the present invention will be best understood by referring to the following detailed description of some illustrative embodiments in conjunction with the accompanying drawings, in which:
FIG. 1 is a schematic perspective view in which a pair of conventional slide rail assemblies are mounted to a rack, and in which an object is mounted on a corresponding pair of rails of the slide rail assemblies;
FIG. 2 schematically shows one of the conventional slide rail assemblies in FIG. 1 in an extended state, in which the third rail is a certain distance away from the first rail;
FIG. 3 is a schematic perspective view in which the slide rail assembly in an embodiment of the present invention is mounted to a rack and is in an extended state;
FIG. 4 is a schematic exploded view of the slide rail assembly in FIG. 3, showing in particular the reinforcement structure of the second rail;
FIG. 5 is a schematic drawing in which the slide rail assembly in FIG. 3 is in a fully pulled out position, and in which the reinforcement structure has two portions corresponding to the first rail and the third rail respectively;
FIG. 6 schematically shows the width of the slide rail assembly in FIG. 3 and how the slide rail assembly is used between a rack and an object which have fixed specifications;
FIG. 7 is a schematic assembled view of the slide rail assembly in FIG. 3;
FIG. 8 is a schematic perspective view of another embodiment of the present invention, in which the second rail is directly and integrally formed with a reinforcement structure; and
FIG. 9 is a schematic sectional view taken along line 9-9 of FIG. 8.

### Detailed Description of the Invention

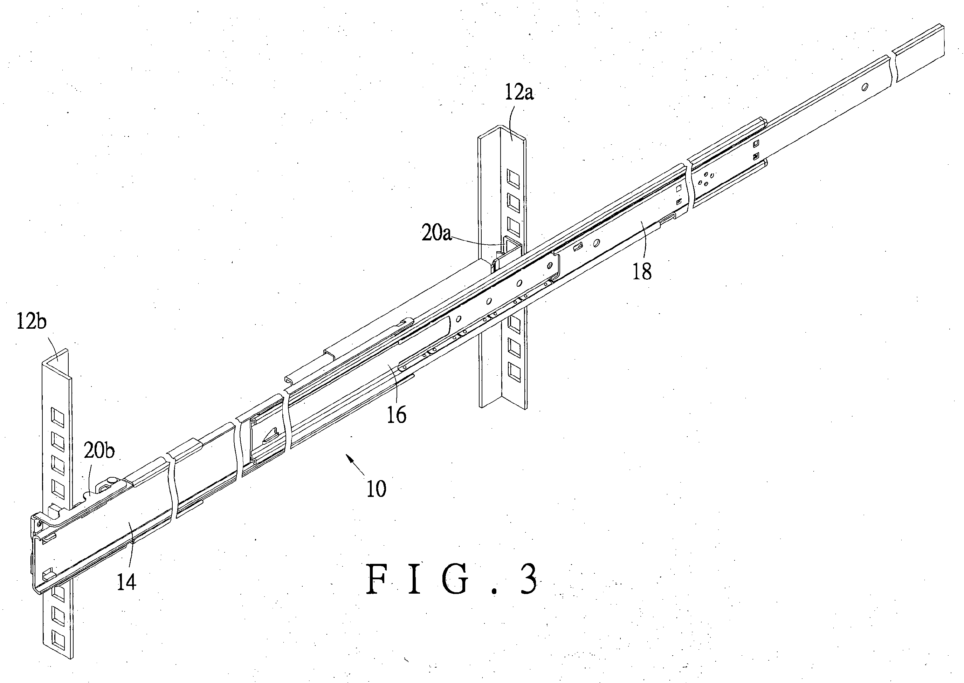

Referring to FIG. 3, the slide rail assembly 10 in an embodiment of the present invention is applied to a first post 12a and a second post 12b of a rack and is in an extended state. More specifically, the slide rail assembly 10 includes a first rail 14, a second rail 16, and a third rail 18. The first rail 14 has two portions (e.g., a front portion and a rear portion) which are mounted to the first post 12a and the second post 12b via a first bracket 20a and a second bracket 20b respectively. The second rail 16 is movably connected to the first rail 14 and is shown in FIG. 3 as at an extended position with respect to the first rail 14. The third rail 18 is movably connected to the second rail 16 and is shown in FIG. 3 as at an extended position with respect to the second rail 16. It should be pointed out that the slide rail assembly 10 can be brought to a retracted state as well and is shown herein in the extended state solely to demonstrate the features of this embodiment of the present invention.

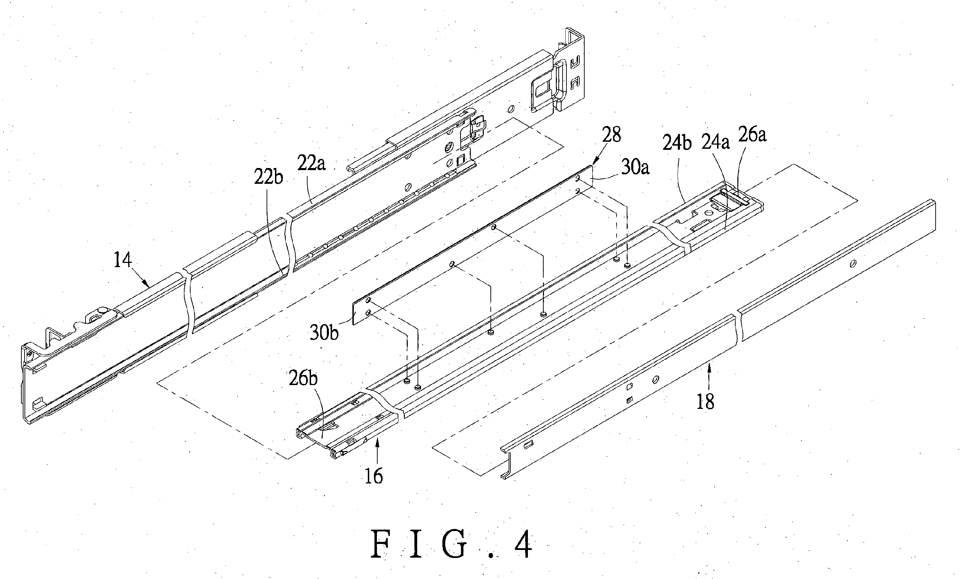

FIG. 4 is an exploded view of the first rail 14, the second rail 16, and the third rail 18. The first rail 14 includes an upper wall 22a and a lower wall 22b. The second rail 16 includes an upper wall 24a, a lower wall 24b, a front portion 26a, a rear portion 26b, and a reinforcement structure 28 correspondingly connected to the second rail 16 and located between the front portion 26a and the rear portion 26b. The reinforcement structure 28 includes a first portion 30a and a second portion 30b. The second portion 30b is located opposite the first portion 30a. In this embodiment, the reinforcement structure 28 is a plate by way of example, wherein the plate can be an elongated one or other structure extending for a certain length. The present invention imposes no limitations on the form of the reinforcement structure 28. The reinforcement structure 28 is longitudinally, correspondingly, and fixedly connected to the second rail 16 and can therefore be viewed as a part of the second rail 16.

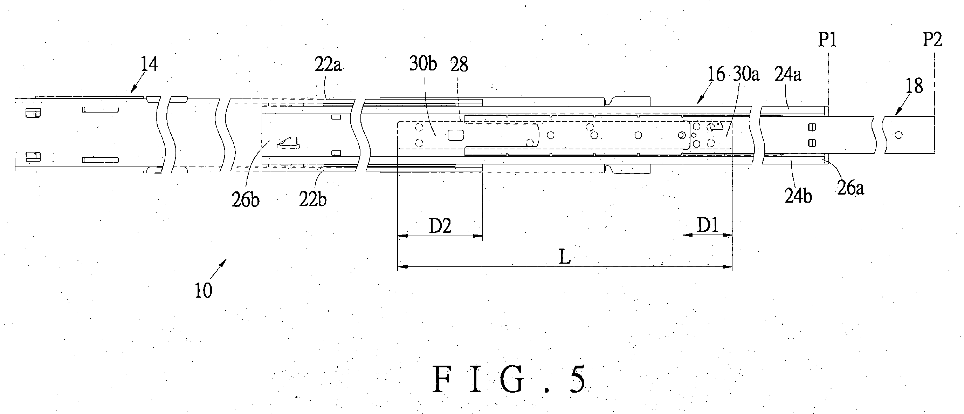

In FIG. 5, the slide rail assembly 10 is in a fully pulled out position, or in an extended state, in which the second rail 16 is at a first extended position P1 with respect to the first rail 14 while the third rail 18 is at a second extended positon P2 with respect to the first rail 14, and the second rail 16 is located between the first rail 14 and the third rail 18. More specifically, the rear portion 26b of the second rail 16 is supported between the upper wall 22a and the lower wall 22b of the first rail 14, and the third rail 18 is supported between the upper wall 24a and the lower wall 24b of the second rail 16 and has a portion located at the front portion 26a of the second rail 16. The reinforcement structure 28 has a length L. When the slide rail assembly 10 is in the extended state, the first portion 30a of the reinforcement structure 28 is at a position corresponding to the third rail 18. For example, the first portion 30a of the reinforcement structure 28 corresponds to the third rail 18 in such a way that they overlap each other by a first distance D1. On the other hand, the second portion 30b of the reinforcement structure 28 is at a position corresponding to the first rail 14. For example, the second portion 30b of the reinforcement structure 28 corresponds to the first rail 14 in such a way that they overlap each other by a second distance D2. Thus, the reinforcement structure 28 enhances the structural strength of the second rail 16 and consequently the connection strength between the third rail 18 and the first rail 14, protecting the second rail 16 from deformation or bending which may otherwise occur due to the weight of the object mounted on the third rail 18 as a result of the third rail 18 being pulled out excessively.

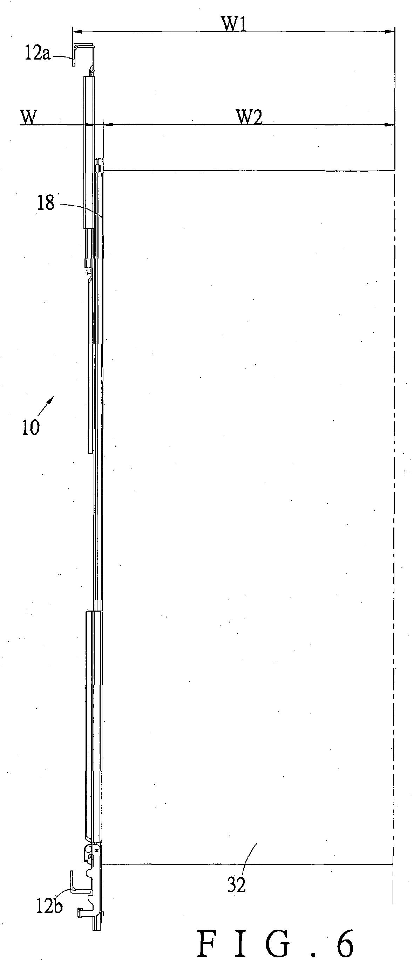

Referring to FIG. 6, an object 32 is mounted to the first post 12a and the second post 12b of a rack via the slide rail assembly 10, wherein the object 32 is mounted to the third rail 18. More specifically, the rack (the first post 12a or the second post 12b) and the object 32 have a total width W1, and the object 32 has a width W2. Therefore, in an environment where the specifications of the object 32 and of the rack are fixed, the slide rail assembly 10 can only have a fixed width W.

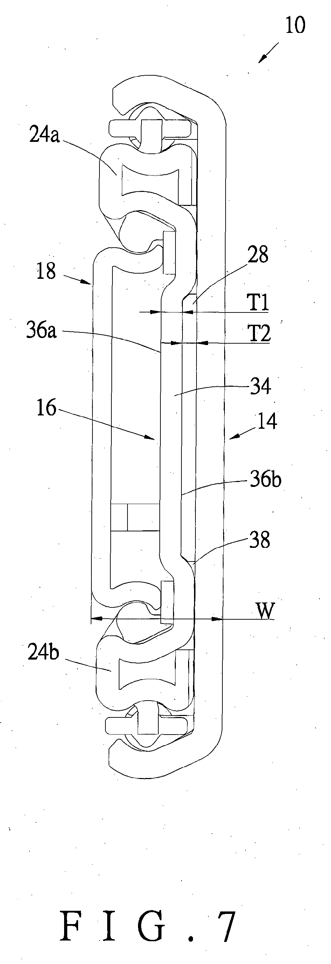

FIG. 7 shows, from another perspective, the first rail 14, the second rail 16, and the third rail 18 of the slide rail assembly 10 in the assembled state, in which the slide rail assembly 10 has the fixed width W. The second rail 16 includes a sidewall 34 extending and connected between the upper wall 24a and the lower wall 24b. The sidewall 34 includes a first surface 36a and a second surface 36b opposite the first surface 36a. The first surface 36a faces the third rail 18 while the second surface 36b faces the first rail 14. The reinforcement structure 28 is connected to the second surface 36b of the second rail 16 and is located between the second surface 36b of the second rail 16 and the first rail 14. In this embodiment, the second rail 16 has a first thickness T1 and further includes a recess 38 in the second surface 36b. Given the limited width W of the slide rail assembly 10, the recess 38 of the second rail 16 allows the reinforcement structure 28 to have a second thickness T2, be fixedly connected to the second rail 16, and lie in the recess 38. And thanks to the reinforcement structure 28, the section of the second rail 16 that is provided with the reinforcement structure 28 is increased in thickness, and the structural strength of a specific portion of the second rail 16 is thus enhanced.

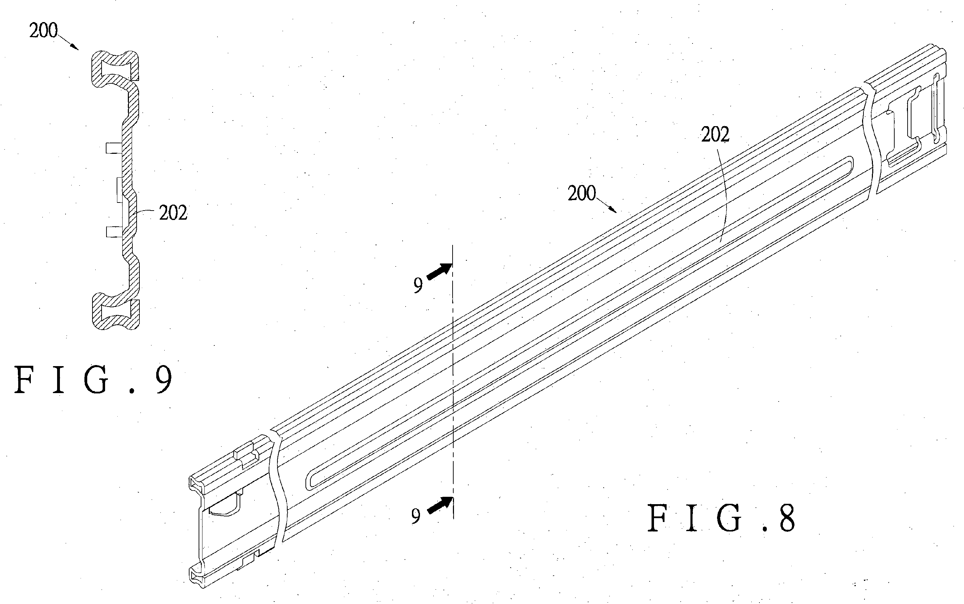

FIG. 8 and FIG. 9 show another embodiment of the present invention, in which the second rail 200 of the slide rail assembly is directly and integrally formed with a reinforcement structure 202. In this embodiment, the reinforcement structure 202 is longitudinally and integrally formed with the second rail 200 and is in the shape of a rib by way of example. The rib increases the structural strength of the second rail 200 and provides the second rail 200 with higher resistance to bending.

While the present invention has been disclosed through the preferred embodiments described above, the embodiments are not intended to be restrictive of the present invention. The scope of patent protection sought by the applicant is defined by the appended claims

## Claims

1. A slide rail assembly (10), comprising:
a first rail (14);
a second rail (16, 200) movably connected to the first rail (14) and including a reinforcement structure (28, 202), wherein the second rail (16, 200) includes a front portion (26a) and a rear portion (26b), and the reinforcement structure (28, 202) is located between the front portion (26a) and the rear portion (26b), and wherein the reinforcement structure (28, 202) includes a first portion (30a) and a second portion (30b) opposite the first portion (30a) and wherein the reinforcement structure (28, 202) is a plate longitudinally and fixedly connected to the second rail (16, 200); and
a third rail (18) movably connected to the second rail (16, 200);
wherein when the slide rail assembly (10) is in an extended state, each of the second rail (16, 200) and the third rail (18) is at an extended position with respect to the first rail (14), the second rail (16, 200) is located between the first rail (14) and the third rail (18), the first portion (30a) of the reinforcement structure (28, 202) is at a position corresponding to the third rail (18), and the second portion (30b) of the reinforcement structure (28, 202) is at a position corresponding to the first rail (14); and the slide rail assembly (10) is adapted for mounting an object (32) to a rack; and wherein the first rail (14) is mounted to the rack, and the third rail (18) is mounted with the object (32).

2. The slide rail assembly (10) as claimed in claim 1, wherein the reinforcement structure (202) is longitudinally and integrally formed with the second rail (200) and forms a rib.

3. The slide rail assembly (10) as claimed in claims 1or2, wherein the first rail (14) is mounted to the rack via two brackets (20a, 20b).

4. The slide rail assembly (10) as claimed in claim 1, wherein the second rail (16) is located between the first rail (14) and the third rail (18) and includes an upper wall (24a), a lower wall (24b), and a sidewall (34) extending and connected between the upper wall (24a) and the lower wall (24b), the sidewall (34) includes a first surface (36a) and a second surface (36b) opposite the first surface (36a), the first surface (36a) faces the third rail (18) while the second surface (36b) faces the first rail (14), and the reinforcement structure (28) is connected to the second rail (16) and located between the second surface (36b) of the second rail (16) and the first rail (14).

5. The slide rail assembly (10) as claimed in claim 4, wherein the second rail (16) further includes a recess (38) in the second surface (36b), and the reinforcement structure (28) is fixedly connected to the second rail (16) and located in the recess (38).

## Patentansprüche

1. Eine Laufschienenmontage (10), umfassend:
eine erste Schiene (14);
eine zweite Schiene (16, 200), die beweglich an der ersten Schiene (14) befestigt ist und eine Verstärkungsstruktur (28, 202) aufweist; wobei die zweite Schiene (16, 200) aus einem vorderen Teil (26a) und aus einem hinteren Teil (26b) besteht; die Verstärkungsstruktur (28, 202) zwischen dem vorderen Teil (26a) und dem hinteren Teil (26b) angeordnet ist; die Verstärkungsstruktur (28, 202) aus einem ersten Teil (30a) und aus einem zweiten Teil (30b) gegenüber dem ersten Teil (30a) besteht, wobei die Verstärkungsstruktur (28, 202) als ein Plättchen gebildet ist, das der Länge nach und fest an der zweiten Schiene (16, 200) befestigt ist; und
eine dritte Schiene (18), die beweglich an der zweiten Schiene (16, 200) befestigt ist;
wenn die Laufschienenmontage (10) ausgezogen ist, jede der zweiten Schiene (16, 200) und der dritten Schiene (18) hinsichtlich der ersten Schiene (14) ausgezogen sind; die zweite Schiene (16, 200) zwischen der ersten Schiene (14) und der dritten Schiene (18) angeordnet ist; der erste Teil (30a) der Verstärkungsstruktur (28, 202) in einer Position in Übereinstimmung mit der dritten Schiene (18) ist, während der zweite Teil (30b) der Verstärkungsstruktur (28, 202) in einer Position in Übereinstimmung mit der ersten Schiene (14) ist; mit der Laufschienenmontage (10) ein Gegenstand (32) an ein Gestell montiert werden kann; die erste Schiene (14) am Gestell und die dritte Schiene (18) mit dem Gegenstand (32) montiert sind.

2. Die Laufschienenmontage (10) nach Anspruch 1, wobei die Verstärkungsstruktur (202) der Länge nach und einstückig mit der zweiten Schiene (200) gebildet ist und eine Rippe bildet.

3. Die Laufschienenmontage (10) nach den Ansprüchen 1 oder 2, wobei die erste Schiene (14) mit zwei Trägern (20a, 20b) am Gestell montiert ist.

4. Die Laufschienenmontage (10) nach Anspruch 1, wobei die zweite Schiene (16) zwischen der ersten Schiene (14) und der dritten Schiene (18) angeordnet ist und eine obere Wand (24a), eine untere Wand (24b) und eine Seitenwand (34) aufweist, die sich erstreckt und zwischen der oberen Wand (24a) und der unteren Wand (24b) befestigt ist; die Seitenwand (34) eine erste Fläche (36a) und eine zweite Fläche (36b) gegenüber der ersten Fläche (36a) aufweist; die erste Fläche (36a) gegenüber der dritten Schiene (18) und die zweite Fläche (36b) gegenüber der ersten Schiene (14) angeordnet sind; die Verstärkungsstruktur (28) an der zweiten Schiene (16) befestigt und zwischen der zweiten Fläche (36b) der zweiten Schiene (16) und der ersten Schiene (14) angeordnet ist.

5. Die Laufschienenmontage (10) nach Anspruch 4, wobei die zweite Schiene (16) weiter eine Vertiefung (38) in der zweiten Fläche (36b) aufweist; die Verstärkungsstruktur (28) fest an der zweiten Schiene (16) befestigt und in der Vertiefung (38) angeordnet ist.

## Revendications

1. Ensemble de glissières (10), **caractérisé par le fait qu'**il comprend :
un premier rail (14) ;
un deuxième rail (16, 200) raccordé de manière mobile au premier rail (14) et comprenant une structure de renforcement (28, 202), le deuxième rail (16, 200) comprend une partie avant (26a) et une partie arrière (26b), et la structure de renforcement (28, 202) est située entre la partie avant (26a) et la partie arrière (26b), et la structure de renforcement (28, 202) comprend une première partie (30a) et une seconde partie (30b) face à la première partie (30a) et la structure de renforcement (28, 202) est une plaque raccordée de manière longitudinale et fixe au deuxième rail (16, 200) ; et
un troisième rail (18) raccordé de manière mobile au deuxième rail (16, 200) ;
lorsque l'ensemble de glissières (10) est déployé, chacun des deuxième rail (16, 200) et troisième rail (18) est en position déployée par rapport au premier rail (14), le deuxième rail (16, 200) est situé entre le premier rail (14) et le troisième rail (18), la première partie (30a) de la structure de renforcement (28, 202) est dans une position correspondant au troisième rail (18), et la seconde partie (30b) de la structure de renforcement (28, 202) est dans une position correspondant au premier rail (14) ; et l'ensemble de glissières (10) est adapté pour monter un objet (32) sur un rack ; et le premier rail (14) est monté sur le rack, et le troisième rail (18) est monté sur l'objet (32).

2. Ensemble de glissières (10) selon la revendication 1, **caractérisé par le fait que** la structure de renforcement (202) est formée de manière longitudinale et intégrale avec le deuxième rail (200) et forme une nervure.

3. Ensemble de glissières (10) selon la revendication 1 ou 2, **caractérisé par le fait que** le premier rail (14) est monté sur le rack via deux supports (20a, 20b).

4. Ensemble de glissières (10) selon la revendication 1, **caractérisé par le fait que** le deuxième rail (16) est situé entre le premier rail (14) et le troisième rail (18) et comprend une paroi supérieure (24a), une paroi inférieure (24b), et une paroi latérale (34) se déployant et raccordée entre la paroi supérieure (24a) et la paroi inférieure (24b), la paroi latérale (34) comprend une première surface (36a) et une seconde surface (36b) face à la première surface (36a), la première surface (36a) fait face au troisième rail (18) alors que la seconde surface (36b) fait face au premier rail (14), et la structure de renforcement (28) est raccordée au deuxième rail (16) et située entre la seconde surface (36b) du deuxième rail (16) et le premier rail (14).

5. Ensemble de glissières (10) selon la revendication 4, **caractérisé par le fait que** le deuxième rail (16) comprend en outre un évidement (38) dans la seconde surface (36b), et la structure de renforcement (28) est raccordée de manière fixe au deuxième rail (16) et située dans l'évidement (38).
